Europäisches Patentamt

European Patent Office

Office européen des brevets

(19)

(11) Veröffentlichungsnummer: **0 232 945**
**A2**

(12) **EUROPÄISCHE PATENTANMELDUNG**

(21) Anmeldenummer: **87200187.0**

(22) Anmeldetag: **09.02.87**

(51) Int. Cl.⁴: **G01N 24/08**

(30) Priorität: **12.02.86 DE 3604281**

(43) Veröffentlichungstag der Anmeldung:
**19.08.87 Patentblatt 87/34**

(84) Benannte Vertragsstaaten:
**DE FR GB NL SE**

(71) Anmelder: **Philips Patentverwaltung GmbH**
**Billstrasse 80**
**D-2000 Hamburg 28(DE)**
**DE**
Anmelder: **N.V. Philips' Gloeilampenfabrieken**
**Groenewoudseweg 1**
**NL-5621 BA Eindhoven(NL)**
**FR GB NL SE**

(72) Erfinder: **McKinnon, Graeme-Colin, Dr.**
**Höschgasse 62**
**CH-8008 Zürich(CH)**

(74) Vertreter: **Hartmann, Heinrich, Dipl.-Ing. et al**
**Philips Patentverwaltung GmbH Billstrasse**
**80 Postfach 10 51 49**
**D-2000 Hamburg 28(DE)**

(54) **Verfahren zur Bestimmung der Kernmagnetisierungsverteilung in einer Schicht eines Untersuchungsbereiches und Kernspintomograph zur Durchführung des Verfahrens.**

(57) Die Erfindung bezieht sich auf eine Sequenz mit sehr kurzer Echozeit. Während der Messung liegt aber ein konstanter Gradient, an dessen Richtung von Sequenz zu Sequenz variiert wird, während sein Beitrag konstant bleibt. Die Verkürzung der Echozeit erfolgt dadurch, daß zunächst beiderseits der anzuregenden Schicht zwei vergleichsweise dicke Bereiche angeregt werden. Die in diesen Bereichen angeregte Kernmagnetisierung wird dephasiert und anschließend wird ein ebenfalls vergleichsweise dicker Bereich durch einen weiteren Hochfrequenzimpuls angeregt, der die anzuregende Schicht sowie einen Teil der Bereiche beiderseits der Schicht umfaßt.

FIG.1

## "Verfahren zur Bestimmung der Kernmagnetisierungsverteilung in einer Schicht eines Untersuchungsbereiches und Kernspintomograph zur Durchführung des Verfahrens"

Die Erfindung betrifft ein Verfahren zur Bestimmung der Kernmagnetisierungsverteilung in einer Schicht eines Untersuchungsbereiches, der in Anwesenheit eines homogenen stationären Magnetfeldes einer Anzahl von Sequenzen ausgesetzt ist, wobei jede Sequenz wenigstens zwei Hochfrequenzimpulse, ein während wenigstens eines Hochfrequenzimpulses wirksames magnetisches Gradientenfeld mit einem senkrecht zur Schicht verlaufenden Gradienten sowie nach den Hochfrequenzimpulsen einen Meßintervall umfaßt, in dem ein weiteres magnetisches Gradientenfeld mit einem in der Schicht verlaufenden und in seiner Richtung veränderbaren Gradienten angelegt und zur Rekonstruktion der Absorptionsverteilung die im Untersuchungsbereich erzeugten Kernspin-Resonanzsignale erfaßt werden. Außerdem betrifft die Erfindung einen Kernspintomographen zur Durchführung dieses Verfahrens.

Bekanntlich nimmt die Amplitude eines Kernspin-Resonanzsignals, das in einem Untersuchungsbereich erzeugt wird, nachdem in Anwesenheit eines stationären homogenen Magnetfeldes ein zu diesem Feld senkrecht verlaufendes hochfrequentes Magnetfeld mit Larmorfrequenz auf ihn eingewirkt hat, exponentiell mit der Zeit ab. Die Zeitkonstante, mit der diese Abnahme erfolgt, ist dabei durch die sogenannte Spin-Spin-Relaxationszeit T2 gegeben -falls das stationäre Magnetfeld exakt homogen ist; anderenfalls ist sie noch kürzer. Die Relaxationszeit T2 hängt einerseits von der Art der Atomkerne ab, deren Resonanz durch das Hochfrequenzfeld angeregt wird und andererseits von der Art ihrer Bindung in dem zu untersuchenden Körper. In verschiedenen Fällen ergeben sich dabei relativ kurve Relaxationszeiten. So liegt beispielsweise die Spin-Spin-Relaxationszeit des Natriumisotops 23, wenn es sich in Zellen des menschlichen Körpers befindet, in der Größenordnung von zwei ms. Es leuchtet ein, daß in solchen Fällen der Zeitraum zwischen der Anregung der Kerne durch den Hochfrquenzimpuls und dem Meßintervall, in dem das Kernspin-Resonanzsignal zum Zweck der Rekonstruktion der Kernmagnetisierungsverteilung empfangen und digitalisiert wird, möglichst kurz sein muß; dieser Zeitraum wird auch als Echozeit TE bezeichnet.

Bei dem eingangs erwähnten sogenannten Rückprojektionsverfahren (vgl. "Röntgenpraxis" 38, Seite 316), bei dem Gradient des während des Meßintervalls wirksamen magnetischen Gradientenfeldes von Sequenz zu Sequenz in seiner Richtung geändert wird, während der Betrag des Gradienten konstant bleibt, ist die Echozeit im Vergleich zu den mehrdimensionalen Fourier-Transformationsverfahren, bei denen zwischen dem Hochfrequenz-Anregungsintervall und dem Meßintervall noch ein Phasenkodierungsintervall liegt, verkürzt, weil das Phasenkodierungsintervall dabei entfällt. Jedoch sind auch dabei die Echozeiten noch relativ groß, wenn die Hochfrequenzanregung mit zwei Hochfrequenzimpulsen erfolgt, wie bei den sogenannten Spin-Echo-Untersuchungen (vgl. "Röntgenpraxis" 38 (1985), Seite 352).

Verwendet man hingegen zur Anregung einer Schicht nur einen einzigen Hochfrequenzimpuls, dann ist die Echozeit -in diesem Fall der Zeitraum zwischen der Mitte des Hochfrequenzimpulses und dem Beginn des Meßintervalls -zwar schon kürzer, jedoch noch nicht kurz genug, wenn eine dünne Schicht angeregt werden soll. Die Dicke der angeregten Schicht ist nämlich der Bandbreite des Hochfrequenzimpulses proportional. Eine dünne Schicht erfordert daher das Anlegen eines -schmalbandigen Hochfrequenzimpulses, der die Echozeit vergrößert. Es kommt hinzu, daß die Polarität des Gradienten des während des Hochfrequenzimpulses wirksamen magnetischen Gradientenfeldes nach dem Hochfrequenzimpuls invertiert werden muß, so daß beim Abschalten dieses Feldes -vor Beginn des Meßintervalls -das zeitliche Integral über dieses Gradientenfeld von der Mitte des Hochfrequenzimpulses bis zum Abschalten Null ist. Dieser Vorgang, der erforderlich ist, um sicherzustellen, daß die Kernmagnetisierung vor Beginn des Meßintervalls überall innerhalb der Schicht die gleiche Phasenlage hat, vergrößert die Echozeit zusätzlich.

Aufgabe der vorliegenden Erfindung ist es, ein Verfahren zur Ermittlung der Kernmagnetisierung in einer Schicht anzugeben, bei dem demgegenüber auch bei dünnen Schichten die Echozeit verkürzt werden kann.

Ausgehend von einem Verfahren der eingangs genannten Art wird diese Aufgabe erfindungsgemäß dadurch gelöst, daß in jeder Sequenz mit wenigstens einem Hochfrequenzimpuls die Kernspinresonanz in zwei beiderseits der Schicht liegenden Bereichen angeregt wird, und daß nach der Dephasierung der angeregten Kernmagnetisierung die Kernmagnetisierung in einem einen Teil der Bereiche sowie die Schicht umfassenden Bereich durch einen weiteren Hochfrequenzimpuls angeregt wird.

Bei der Erfindung werden zunächst die Kerne in zwei die anzuregende Schicht begrenzenden Bereichen durch wenigstens einen Hochfrequenzimpuls angeregt. Dadurch kippt der resultierende Kernmagnetisierungsvektor in diesen Bereichen - vorzugsweise um 90° -aus der Richtung des stationären homogenen Magnetfeldes. Die Kernmagnetisierung in diesem Bereich dephasiert -gegebenenfalls durch ein zusätzlich angelegtes magnetisches Gradientenfeld. Wenn danach durch den weiteren Hochfrequenzimpuls in einen Teil dieser Bereiche und die Schicht umfassender Bereich angeregt wird, dann liefern die in den beiden Bereichen durch den weiteren Hochfrequenzimpuls angeregten Kerne keinen Beitrag zu dem nach diesem Impuls auftretenden Kernspin-Resonanzsignal, weil sie dephasiert sind, so daß das Kernspin-Resonanzsignal Informationen lediglich über die zuvor noch nicht angeregte Schicht enthält. -Der weitere Hochfrequenzimpuls ist dabei wesentlich breitbandiger als zur Anregung der Schicht erforderlich. Infolgedessen ist seine Dauer wesentlich kürzer, wodurch die Echozeit herabgesetzt werden kann.

Eine Weiterbildung der Erfindung sieht vor, daß die Kernmagnetisierung in den beiderseits der Schicht befindlichen Bereichen durch je einen Hochfrequenzimpuls in Verindung mit einem magnetischen Gradientenfeld mit senkrecht zur Schicht verlaufendem Gradienten angeregt wird. Wenn in weiterer Ausgestaltung der Erfindung hinzu kommt, daß die beiden Hochfrequenzimpulse den gleichen zeitlichen Verlauf haben und daß die Polaritäten der Gradienten des magnetischen Gradientenfeldes bei den beiden Hochfrequenzimpulsen einander entgegengesetzt sind, ergeben sich besonders einfache Verhältnisse, da beide Hochfrequenzimpulse den gleichen Signalverlauf haben.

Eine andere Ausgestaltung der Erfindung sieht vor, daß daß die Kernmagnetisierung in den beiden Bereichen in Anwesenheit eines magnetischen Gradientenfeldes mit senkrecht zur Schicht verlaufendem Gradienten durch einen einzigen Hochfrequenzimpuls angeregt wird, dessen zeitlicher Verlauf so gewählt ist, daß in dem Frequenzspektrum des Impulses die Frequenzbereiche, die der Schicht zugeordnet sind, fehlen und die benachbarten Frequenzbereiche vorhanden sind. Hierbei wird also nur ein einziger Hochfrequenzimpuls zur Anregung der beiden die Schicht begrenzenden Bereiche benötigt. Jedoch ist sein zeitlicher Verlauf komplizierter als bei den beiden zuvor erwähnten Impulsen. Seine Dauer kann nicht kürzer sein (bei gleichem Gradienten des während dieses Impulses wirksamen Gradientenfeldes) als die eines Impulses, der genügend schmalbandig ist, um nur diese Schicht anzuregen. Da die eigentliche Anregung der Schicht jedoch durch den weiteren Hochfrequenzimpuls erfolgt, hat dies keinen Einfluß auf die Dauer der Echozeit. Wesentlich ist nur, daß die Zeit, die von dem bzw. den Hochfrequenzimpulsen zur Anregung der beiderseits der Schicht befindlichen Bereiche bis zu dem weiteren Hochfrequenzimpuls verstreicht, der die Kernmagnetisierung in der Schicht anregt, klein ist im Vergleich zur Spin-Gitter-Relaxationszeit T1 der in der Schicht anzuregenden Atomkerne. Anderenfalls würden die in den Bereichen beiderseits der Schicht vorhandenen Atomkerne der gleichen Art einen nicht mehr zu vernachlässigenden Beitrag zu dem Kernspin-Resonanzsignal liefern.

Dies ist auch der Grund dafür, weshalb der bzw. die im Hochfrequenzimpuls(e) zur Anregung der beiderseits der Schicht befindlichen Bereiche 90° Impulse sein sollen, so daß die Kernmagnetisierung in den angeregten Bereichen um 90° aus der Richtung des homogenen stationären Magnetfeldes gekippt wird.

Ein Kernspintomograph zur Durchführung des erfindungsgemäßen Verfahrens ist versehen mit einem Magneten zur Erzeugung eines homogenen stationären Magnetfeldes, einer Hochfrequenz-Spulenanordnung zur Erzeugung eines hochfrequenten zum stationären Magnetfeld senkrechten Magnetfeldes, einer Gradienten-Spulenanordnung zur Erzeugung von in Richtung des stationären Magnetfeldes verlaufenden Magnetfeldern mit in verschiedenen Richtungen verlaufenden Gradienten, einem Hochfrequenzgenerator zur Speisung der Hochfrequenz-Spulenanordnung und mit Generatoren zur Speisung der Gradientenspulen sowie mit einer Steuereinheit zur Steuerung des Hochfrequenzgenerators und der Generatoren und ist dadurch gekennzeichnet, daß die Steuerung so programmiert ist, daß zunächst wenigstens ein Hochfrequenzimpuls und ein magnetisches Gradientenfeld mit zur Schicht senkrechtem Gradienten erzeugt wird derart, daß in zwei beiderseits einer Schicht befindlichen Bereichen die Kernmagnetisierung angeregt wird und daß dann ein weiterer, - schmalbandiger Impuls erzeugt wird, der die Kernmagnetisierung in einem einen Teil der Bereiche und die Schicht einschliessenden Bereich anregt.

Die Erfindung wird nachstehend anhand der Zeichnung näher erläutert. Es zeigen:

Fig. 1 ein Kernspin-Untersuchungsgerät, bei dem die Erfindung anwendbar ist,

Fig. 2 ein Blockschaltbild eines solchen Gerätes,

Fig. 3 den zeitlichen Verlauf verschiedener Signale bei einer erfindungsgemäßen Sequenz,

Fig. 4a bis 4e verschiedene Diagramme zur Erläuterung der Wirkung der Sequenz.

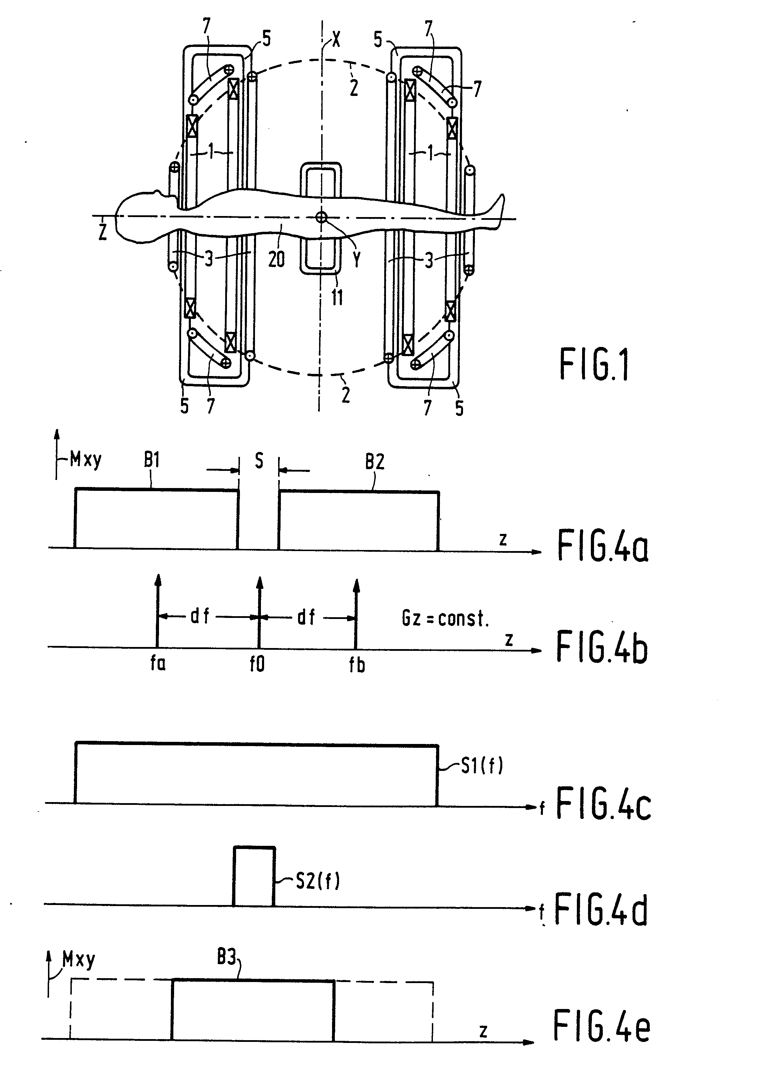

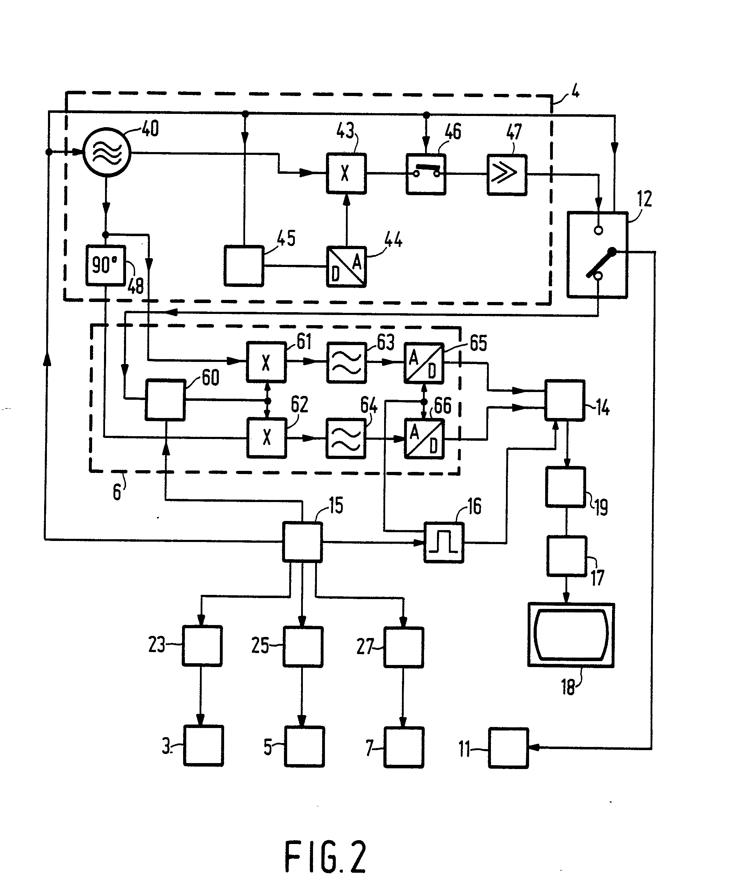

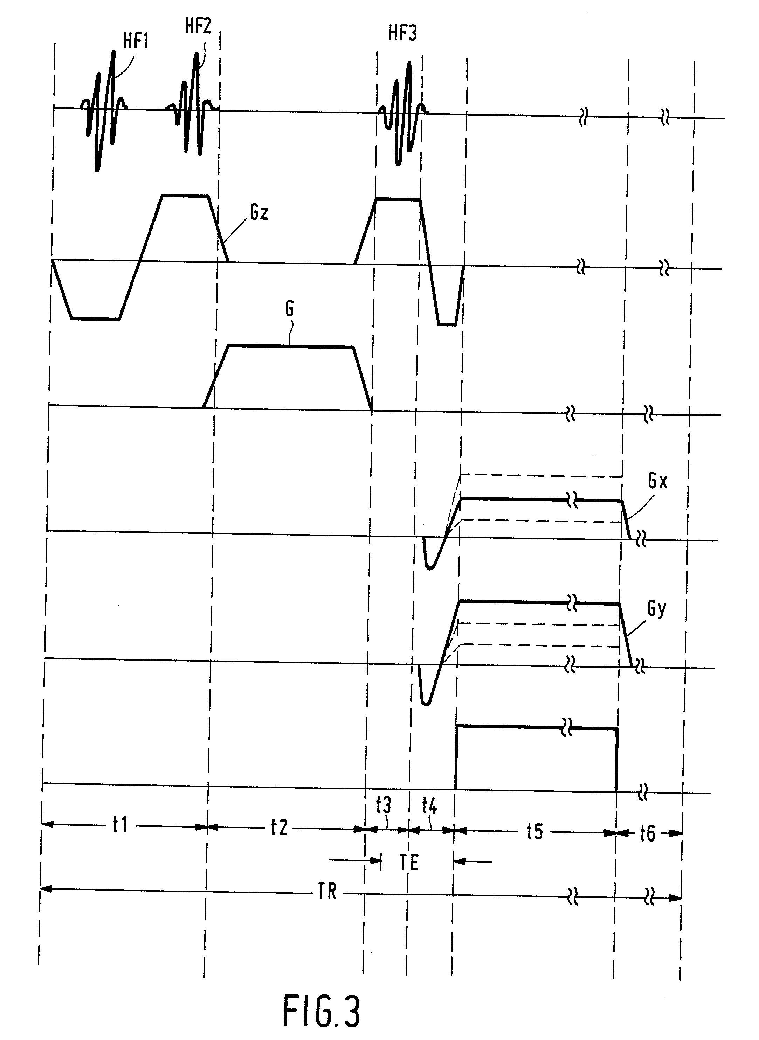

Der in Fig. 1 schematisch dargestellte Kerspin-Tomograph enthält eine aus vier Spulen 1 bestehende Anordnung zur Erzeugung eines homogenen stationären Magnetfeldes, das in der Größenordnung von einigen Zehntel T bis einigen T liegen kann. Dieses Feld verläuft in z-Richtung eines kartesischen Koordinatensystems. Die zur z-Achse konzentrisch angeordneten Spulen 1 können auf einer Kugeloberfläche 2 angeordnet sein. Im Innern dieser Spulen befindet sich der zu untersuchende Patient 20.

Zur Erzeugung eines in z-Richtung verlaufenden und sich in dieser Richtung linear ändernden Magnetfeldes Gz sind vier Spulen 3 vorzugsweise auf der gleichen Kugeloberfläche angeordnet. Weiterhin sind vier Spulen 7 vorgesehen, die ein ebenfalls in z-Richtung verlaufendes magnetisches Gradientenfeld Gx erzeugen, dessen Gradient jedoch in x-Richtung verläuft. Ein in z-Richtung verlaufendes magnetisches Gradientenfeld Gy mit einem Gradienten in y-Richtung wird von vier Spulen 5 erzeugt, die mit den Spulen 7 identisch sein können, die jedoch diesen gegenüber um 90° räumlich versetzt angeordnet sind. Von diesen vier Spulen 5 sind in Fig. 1 nur zwei dargestellt.

Da jede der drei Spulenanordnungen 3, 5 und 7 zur Erzeugung der magnetischen Gradientenfelder Gz, Gy und Gx symmetrisch zur Kugeloberfläche 2 angeordnet ist, ist die Feldstärke im Kugelzentrum, das gleichzeitig den Koordinatenursprung des erwähnten kartesischen x,y,z-Koordiantensystem bildet, nur durch das stationäre homogene Magnetfeld der Spulenanordnung 1 bestimmt. Weiterhin ist eine Hochfrequenzspule 11 symmetrisch zur Ebene z=0 des Koordinatensystems angeordnet, die so ausgebildet ist, das damit ein im wesentlichen homogenes und in x-Richtung, d.h. senkrecht zur Richtung des stationären homogenen Magnetfeldes verlaufendes hochfrequentes Magnetfeld erzeugt wird. Der Hochfrequenzspule wird während jedes Hochfrequenzimpulses ein hochfrequenter modulierter Strom von einem Hochfrequenzgenerator zugeführt. Im Anschluß an einen oder mehrere Hochfrequenzimpulse dient die Hochfrequenzspule 11 zum Empfangen der durch Kernspinresonanz im Untersuchungsbereich erzeugten Echosignale. Statt dessen könnte aber auch eine gesonderte Hochfrequenz-Empfangsspule verwendet werden.

Fig. 2 zeigt ein vereinfachtes Blockschaltbild dieses Kernspintomographen. Die Hochfrequenzspule 11 ist über eine Umschalteinrichtung 12 einerseits an einen Hochfrequenzgenerator 4 und andererseits an einen Hochfrequenzempfänger 6 angeschlossen.

Der Hochfrequenzgenerator 4 enthält einen in seiner Frequenz digital steuerbaren Hochfrequenzoszillator 40, der Schwingungen mit einer Frequenz gleich der Larmorfrequenz derjenigen Atomkerne, deren räumliche Verteilung in der Schicht ermittelt werden soll, bei der von den Spulen 1 erzeugten Feldstärken aufweist. Die Larmorfrequenz $f$ berechnet sich bekanntlich nach der Beziehung $f = cB$, wobei B die magnetische Induktion in dem stationären homogenen Magnetfeld darstellt und c das gyromagnetische Verhältnis, das beispielsweise für Wasserstoffprotonen 42,56 MHz/T und für das Natriumisotop Na 23 11,26 MHz/T beträgt. Der Ausgang des Oszillators 40 ist mit einem Eingang einer Mischstufe 43 verbunden. Der Mischstufe 43 wird ein zweites Eingangssignal von einem Digital-Analog-Wandler 44 zugeführt, dessen Eingang mit einem digitalen Speicher 45 verbunden ist. Aus dem Speicher 45 wird -gesteuert durch eine Steuereinrichtung 15 -eine Folge von ein Hüllkurvensignal darstellenden digitalen Datenworten ausgelesen.

Die Mischstufe 43 verarbeitet die ihr zugeführten Eingangssignale so, daß an ihrem Ausgang die mit dem Hüllkurvensignal modulierte Trägerschwingung erscheint. Das Ausgangssignal der Mischstufe 43 wird über einen von der Steuereinrichtung 15 gesteuerten Schalter 46 einem Hochfrequenz-Leistungsverstärker 47 zugeführt, dessen Ausgang mit der Umschalteinrichtung 12 verbunden ist. Diese wird ebenfalls durch die Steuereinrichtung 15 gesteuert.

Der Empfänger 6 enthält einen Hochfrequenzverstärker 60, der mit der Umschalteinrichtung verbunden ist und dem die in der Hochfrequenzspule 11 induzierten, durch Kernspinresonanz hervorgerufenen Echosignale zugeführt werden, wenn die Umschalteinrichtung 12 entsprechend gesteuert ist. Der Verstärker 60 besitzt einen von der Steuereinrichtung 15 gesteuerten Stummschalteingang, über den er gesperrt werden kann, so daß die Verstärkung praktisch Null ist. Der Ausgang des Verstärkers 60 ist mit den ersten Eingängen zweier multiplikativer Mischstufen 61 und 62 verbunden, die jeweils ein dem Produkt ihrer Eingangssignale entsprechendes Ausgangssignal liefern. Den zweiten Eingängen der Mischstufen 61 und 62 wird ein Signal mit der Frequenz des Oszillators 40 zugeführt, wobei zwischen den Signalen an den beiden Eingängen eine Phasenverschiebung von 90° besteht. Diese Phasenverschiebung wird mit Hilfe eines 90°-Phasendrehgliedes 48 erzeugt, dessen Ausgang mit dem Eingang der Mischstufe 62 und dessen Eingang mit dem Eingang der Mischstufe 61 und mit dem Ausgang des Oszillators 40 verbunden ist.

Die Ausgangssignale der Mischstufe 61 und 62 werden über Tiefpässe 63 und 64, die die vom Oszillator 40 gelieferte Frequenz sowie alle darüber liegenden Frequenzen unterdrücken und niederfrequente Anteile durchlassen, je einem Analog-Digital-Wandler 65 bzw. 66 zugeführt. Dieser setzt die analogen Signale der einen Quadratur-Demodulator bildenden Schaltung 61...64 in digitale Datenworte um, die einem Speicher 14 zugeführt werden. Die Analog-Digital-Wandler 65 und 66 sowie der Speicher 14 erhalten ihre Taktimpulse von einem Taktimpulsgenerator 16, der über eine Steuerleitung von der Steuereinrichtung 15 blockiert bzw. freigegeben werden kann, so daß nur in einem durch die Steuereinrichtung 15 definierten Meßintervall die von der Hochfrequenzspule 11 gelieferten, in den Nieder frequenzbereich transponierten Signale in eine Folge digitaler Datenworte umgesetzt und in dem Speicher 14 gespeichert werden können.

Die drei Spulenanordnungen 3, 5 und 7 werden von Stromgeneratoren 23, 25 und 27 jeweils mit einem Strom versorgt, dessen zeitlicher Verlauf durch die Steuereinheit 15 steuerbar ist. Die im Speicher 14 gespeicherten Datenworte bzw. Abtastwerte werden einem Rechner 17 zugeführt, der daraus die räumliche Verteilung der Kernmagnetisierung in der untersuchten Schicht ermittelt und die ermittelte Verteilung an einer geeigneten Wiedergabeeinheit, z.B. einem Monitor 18, ausgibt.

In Fig. 3 ist der zeitliche Verlauf von verschiedenen, mit der Schaltung nach Fig. 2 empfangenen oder erzeugten Signalen für eine einzige Sequenz dargestellt. Jede Sequenz setzt sich aus sechs unmittelbar aufeinanderfolgenden Zeitintervallen t1...t6 zusammen.

Im ersten Zeitintervall t1 werden die Atomkerne der nachzuweisenden Art in zwei Bereichen B1 und B2 -vgl. Fig. 4a in Kernspinresonanz gebracht, die sich unmittelbar beiderseits der Schicht S befinden, innerhalb der die Kernmagnetisierungsverteilung bestimmt werden soll. Zu diesem Zweck wird im Zeitintervall t1 der Hochfrequenzerzeuger 4 zumindest zeitweise über den Schalter 12 mit der Hochfrequenzspule 11 verbunden, so daß -vgl. erste Zeile von Fig. 3 -zwei 90° Impulse HF1 und HF2 erzeugt werden. Gleichzeitig wird die Hochfrequenz-Spulenanordnung 3 von einem Strom durchflossen, dessen zeitlicher Verlauf durch die Steuereinheit 15 so gesteuert wird, daß die Spulenanordnung 3 ein magnetisches Gradientenfeld Gz erzeugt, dessen Gradient beim zweiten Hochfrequenzimpuls HF2 die entgegengesetzte Polarität hat wie beim ersten Hochfrequenzimpuls HF1 (vgl. zweite Zeile von Fig. 3).

Die Wirkung dieser Maßnahme läßt sich anhand der Fig. 4a erklären, die den erwünschten -idealisierten -Verlauf der zum homogenen stationären Magnetfeld senkrechten Kernmagnetisierung als Funktion des Ortes z zeigt. In Fig.4a ist mit S die Schicht bezeichnet, deren räumliche Kernmagnetisierungsverteilung ermittelt werden soll. Sie wird beiderseits von je einem Bereich B1 und B2 begrenzt. Die Dicke der Bereiche B1 und B2, d.h. ihre Abmessungen in z-Richtung, ist wesentlich größer als die Dicke der Schicht S bzw. als deren Abmessungen in z-Richtung. Vorzugsweise sind die beiden Bereiche B1 und B2 gleich dick.

Die Differenz zwischen den Larmorfrequenzen im Ursprung des Koordinatensystems und am Ort z, die sich bei Anlegen eines magnetischen Gradntenfeldes mit in z-Richtung verlaufenden Gradnten ergibt, ist bekanntlich dem Produkt der z-Koordinate und des Gradienten proportional. Demgegemäß läßt sich bei einem konstanten Gradnten in z-Richtung jeder zur z-Achse senkrechten Ebene eine bestimmte Larmorfrequenz zuordnen. Demgemäß sind den Mitten der Bereiche B1 und B2 die Frequenzen fa und fb zugeordnet, während der Mitte der Schicht S die Frequenz fo zugeordnet ist, wie sich aus Fig. 4b ergibt. Der Abstand der Frequenz fo zu den Frequenzen fa und fb beträgt df, wenn wie vorausgesetzt die Bereiche gleich dick sind.

Aus Fig. 4b folgt demgemäß, daß die Kernmagnetisierung in den Bereichen B1 und B2 angeregt werden kann, wenn -bei jeweils gleichem Gradientenfeld Gz -zwei Hochfrequenzimpulse erzeugt werden, deren Bandbreite der Dicke der Bereiche B1 bzw. B2 proportional ist und deren Mittenfrequenz bei fa bzw. fb liegt. Dies würde voraussetzen, daß bei der Schaltung nach Fig. 2 die Oszillatorfrequenz zwischen dem ersten und dem zweiten Hochfrequenzimpuls von fa auf fb umgeschaltet wird, während das aus dem Speicher 45 entnommene Hüllkurvensignal in beiden Fällen gleich sein kann.

Die Erzeugung der beiden Hochfrequenzimpulse zur Anregung der Schichten B1 und B2 kann noch weiter vereinfacht werden, wenn die Mitte der Schicht S in der Ebene z=0 ist, wo voraussetzungsgemäß die Induktion des magnetischen Gradientenfeldes Gz gleich Null ist. Kehrt man nämlich zwischen den beiden Hochfrequenzimpulsen die Polarität des Gradientenfeldes um, dann ergibt sich während des ersten Impulses in dem einen Bereich die gleiche z-Abhängigkeit der magnetischen Induktion wie während des zweiten Impulses im anderen Bereich. Infolgedessen können die beiden Impulse das gleiche Spektrum bzw. den gleichen zeitlichen Verlauf haben und muß die Oszillatorfrequenz zwischen den beiden Impulsen nicht umgeschaltet werden, sondern kann ihren Wert (fa) während der beiden Impulse beibehalten.

Es ist aber auch möglich, beide Bereiche gleichzeitig und mit nur einem einzigen Impuls anzuregen, dessen Spektrum der Differenz der beiden in Fig. 4c und 4d dargestellten Spektren entspricht. Das Spektrum S1(f) ist so breit, das es den gesamten Bereich zwischen der linken Grenze des Bereichs B1 und der rechten Grenze des Bereichs B2 anregen kann. Das Spektrum S2(f) entspricht dem eines Impulses, der für sich allein nur die Schicht S anregen könnte. Subtrahiert man die beiden Spektren, dann ergibt sich ein breites Spektrum mit einer Lücke in der Mitte. Der zeitliche Verlauf des Hüllkurvensignals eines Impulses, dessen Frequenzspektrum der Differenz S1(f)-S2(f) entspricht, ergibt sich, wenn beide Spektralfunktionen S1(f) und S2(f) getrennt einer Fourier-Transformation vom Frequenzbereich in den Zeitbereich unterworfen werden und die resultieren den Signale voneinander subtrahiert werden. Das so gewonnene Hüllkurvensignal wird im Speicher 45 gespeichert und in der Mischstufe 43 mit dem Ausgangssignal des Oszillators gemischt, dessen Frequenz in diesem Fall fo ist.

Die entweder mit einem oder zwei Hochfrequenzimpulsen innerhalb der Zeit t1 angeregte Kernmagnetisierung muß dephasiert sein, bevor die eigentliche Anregung der Schicht erfolgt. Nur in diesem Fall ist es möglich, nach Anregung mit einem breitbandigen (kurzen) Hochfrequenzimpuls Kernresonanzsignale nur aus der Schicht zu erhalten. Die Dephasierung erfolgt zum Teil schon dadurch, daß nach dem zweiten Hochfrequenzimpuls die Polarität des Gradientenfeldes Gz nicht invertiert wird. Falls diese Dephasierung jedoch nicht ausreicht, wird in dem auf das Zeitintervall t1 folgenden Zeitintervall t2 ein magnetisches Gradientenfeld G eingeschaltet, das in diesem Intervall seine Polarität beibehält (vgl. Zeile 3 in Fig. 3). Grundsätzlich kann der Gradient dieses Feldes in x-, y-oder z-Richtung verlaufen.

In dem auf das Intervall t2 folgenden Zeitintervall t3 wird ein weiterer Hochfrequenzimpuls HF3 erzeugt (Zeile 1) und erneut ein magnetisches Gradientenfeld mit während des Hochfrequenzimpulses konstantem Gradienten in z-Richtung eingeschaltet (Zeile 2). Der Hochfrequenzimpuls HF3 hat die gleiche Hüllkurve wie die Hochfrequenzimpulse HF1 und HF2. Er hat also auch die gleiche Bandbreite und die gleiche Dauer. Allerdings muß die Trägerfrequenz dieses Impulses fo entsprechen - (vgl. Fig. 4b), d.h. die Oszillatorfrequenz muß nach den beiden ersten Hochfrequenzimpulsen HF1 und HF2 von fa auf fo umgeschaltet werden. Da der Hochfrequenzimpuls HF3 die gleiche Bandbreite aufweist wie die Hochfrequenzimpulse HF1 und HF2, würde durch ihn an sich die Kernmagnetisierung in einem Bereich B3 angeregt werden, der wesentlich breiter ist als die Schicht S, d.h. also auch in einem Teil der Bereiche B1 und B2. Da in diesen Teilen die Kernmagnetisierung jedoch - schon dephasiert ist, ergibt sich aus diesen Teilen kein Beitrag zum Kernspinresonanzsignal. Dieses ist allein von der Kernmagnetisierungsverteilung innerhalb der Schicht S abhängig.

Der Hochfrequenzimpuls HF3 kann noch breitbandiger sein als die Hochfrequenzimpulse HF1 und HF2, so lange dadurch nicht eine Kernmagnetisierung links vom Bereich B1 und rechts vom Bereich B2 angeregt wird; die linke Grenze des Bereichs B3 fällt dann mit der linken Grenze des Bereichs B1 zusammen und die rechte Grenze mit der rechten Grenze des Bereichs B2, wie gestrichelt angedeutet. Der Hochfrequenzimpuls hat dann eine noch kürzere Dauer, jedoch muß für diesen Fall im Speicher 45 zusätzlich ein weiteres Hüllkurvensignal gespeichert sein, das im Zeitintervall t3 mit der Frequenz fo multipliziert wird.

In dem auf das Intervall t3 folgenden Zeitintervall t4 wird die Polarität des Gradientenfeldes Gz umgekehrt und das Gradientenfeld nach einer bestimmten Zeit abgeschaltet. Der zeitliche Verlauf des Gradientenfeldes ist dabei so gewählt, daß das zeitliche Integral über dieses Feld von der Mitte des Hochfrequenzimpulses HF3 bis zum Abschalten dieses Gradientenfeldes gerade Null ist. In diesem Fall ist die Kernmagnetisierung in der angeregten Schicht S unabhängig von z.

Weiterhin werden im Zeitintervall t4 die Gradientenfelder Gx und Gy eingeschaltet (vgl. Zeilen 4 und 5 von Fig. 3), wobei sie während des Intervalls ihre Polarität umkehren, bis am Ende von t4 der Gradient einen Wert erreicht hat, den er während des darauffolgenden Meßintervalls t5 beibehält. Der zeitliche Verlauf der Gradientenfelder Gx und Gy im Intervall t4 ist dabei so bemessen, daß das zeitliche Integral über jedes der beiden Gradientenfelder am Ende des Zeitintervalls t4 bzw. zu Beginn des Zeitintervalls t5 gerade den Wert Null erreicht hat.

In dem daran anschließenden Zeitintervall t5 wird das Kernspin-Resonanzsignal empfangen (der Schalter 12 befindet sich dann in der aus Fig. 2 ersichtlichen Stellung), und der Taktgeber 16 wird von der Steuereinheit 15 freigegeben, wie in Fig. 3 in der sechsten Zeile angedeutet ist. Infolgedessen werden während dieses Zeitintervalls die empfangenen Kernspinresonanzsignale abgetastet und die Abtastwerte als digitale Datenworte in dem Speicher 14 gespeichert. Die Gradientenfelder Gx und Gy werden während dieser Messung nicht geändert. Sie werden jedoch, wie gestrichelt angedeutet, von Sequenz zu Sequenz geändert, und zwar so, daß ihr Betrag konstant bleibt, während sich ihre Richtung ändert. Am Ende des Meßintervalls t5 wird der Taktgeber 16 blockiert, d.h. es werden keine weiteren Abtastwerte mehr erfaßt und gespeichert.

Zu Beginn des darauffolgenden Zeitintervalls t6 werden auch die magnetischen Gradientenfelder Gx und Gy abgeschaltet. In diesem Zeitintervall - das in der Regel das längste Zeitintervall der Sequenz ist -sollen sich die Kernspins wieder in die z-Richtung orientieren, wonach eine neue Sequenz appliziert werden kann.

Wie die Fig. 3 zeigt, entspricht die Echozeit TE der Summe des Zeitintervalls t4 und der Hälfte des Hochfrequenzimpulses HF3. Da das Intervall t4 im wesentlichen durch die Dephasierung in z-Richtung bedingt ist und diese wiederum von der Wirkungszeit dieses Gradienten während des Hochfrequenzimpulses abhängt, werden beide Anteile und mithin das Echosignal um so kürzer, je kürzer, d.h. je breitbandiger, der Hochfrequenzimpuls HF3 ist. Da dessen Dauer bzw. Bandbreite von der Dicke der anzuregenden Schicht praktisch nicht abhängt, ist es möglich, auch bei Anregung verhältnismäßig dünner Schichten sehr kurze Echozeiten zu erhalten, deren untere Grenze dann nur noch von der Geschwindigkeit abhängt, mit der die Gradientenfelder umgeschaltet werden können.

Obwohl die Erfindung vorstehend in Verbindung mit der Anregung einer zur z-Achse senkrechten Schicht· erläutert wurde, ist es ebenso möglich, das erfindungsgemäße Verfahren bei der Anregung einer zur x-bzw. zur y-Achse senkrechten Schicht anzuwenden. In diesem Fall muß lediglich das magnetische Gradientenfeld in x-bzw. in y-Richtung den in Zeile zwei von Fig. 3 dargestellten Verlauf haben, während das magnetische Gradientenfeld Gz den in Zeile vier bzw. fünf dargestellten Verlauf haben muß.

## Ansprüche

1. Verfahren zur Bestimmung der Kernmagnetisierungsverteilung in einer Schicht eines Untersuchungsbereiches, der in Anwesenheit eines homogenen stationären Magnetfeldes einer Anzahl von Sequenzen ausgesetzt ist, wobei jede Sequenz wenigstens zwei Hochfrequenzimpulse, ein während wenigstens eines Hochfrequenzimpulses wirksames magnetisches Gradientenfeld mit einem senkrecht zur Schicht verlaufenden Gradienten sowie nach den Hochfrequenzimpulsen einen Meßintervall umfaßt, in dem ein weiteres magnetisches Gradientenfeld mit einem in der Schicht verlaufenden und in seiner Richtung veränderbaren Gradienten angelegt und zur Rekonstruktion der Absorptionsverteilung die im Untersuchungsbereich erzeugten Kernspin-Resonanzsignale erfaßt werden,
dadurch gekennzeichnet, daß in jeder Sequenz mit wenigstens einem Hochfrequenzimpuls die Kernspinresonanz in zwei beiderseits der Schicht (S) liegenden Bereichen (B1, B2) angeregt wird, und daß nach der Dephasierung der angeregten Kernmagnetisierung die Kernmagnetisierung in einem einen Teil der Bereiche sowie die Schicht umfassenden Bereich (B3) durch einen weiteren Hochfrequenzimpuls angeregt wird.

2. Verfahren nach Anspruch 1,
dadurch gekennzeichnet, daß in jeder Sequenz vor dem weiteren Hochfrequenzimpuls (HF3) und nach dem ihm vorangehenden Hochfrequenzimpuls -

(HF2) ein zusätzliches magnetisches Gradientenfeld (G) zum Zwecke der Dephasierung angelegt wird.

3. Verfahren nach einem der Ansprüche 1 bis 2,
dadurch gekennzeichnet, daß die Kernmagnetisierung in den beiderseits der Schicht befindlichen Bereichen (B1, B2) durch je einen Hochfrequenzimpuls (HF1, HF2) in Verbindung mit einem magnetischen Gradientenfeld (Gz) mit senkrecht zur Schicht verlaufendem Gradienten angeregt wird.

4. Verfahren nach Anspruch 3,
dadurch gekennzeichnet, daß die beiden Hochfrequenzimpulse (HF1, HF2) den gleichen zeitlichen Verlauf haben und daß die Polaritäten der Gradienten des magnetischen Gradientenfeldes (Gz) bei den beiden Hochfrequenzimpulsen einander entgegengesetzt sind.

5. Verfahren nach Anspruch 1,
dadurch gekennzeichnet, daß die Kernmagnetisierung in·den beiden Bereichen in Anwesenheit eines magnetischen Gradientenfeldes. mit senkrecht zur Schicht verlaufendem Gradienten durch einen einzigen Hochfrequenzimpuls angeregt wird, dessen zeitlicher Verlauf so gewählt ist, daß in dem Frequenzspektrum des Impulses die Frequenzbereiche, die der Schicht zugeordnet sind, fehlen und die benachbarten Frequenzbereiche vorhanden sind.

6. Verfahren nach einem der Ansprüche 1 bis 5,
dadurch gekennzeichnet, daß der zeitliche Verlauf des während und nach dem weiteren Impuls (HF3) wirksamen magnetischen Gradientenfeldes (Gz) mit zur Schicht senkrechtem Gradienten so gewählt ist, daß das zeitliche Integral über den Gradienten von der Mitte des Hochfrequenzimpulses bis zum Abschalten des Gradientenfeldes Null ist.

7. Verfahren nach einem der vorhergehenden Ansprüche,
dadurch gekennzeichnet, daß das weitere magnetische Gradientenfeld nach dem weiteren Hochfrequenzimpuls (HF3) mit einem zum Gradienten in dem Meßintervall (t5) entgegengesetzten Gradienten eingeschaltet wird, und daß es einen solchen zeitlichen Verlauf hat, daß das zeitliche Integral über dieses Feld (Gx, Gy) zu Beginn des Meßintervalls (t5) den Wert Null hat.

8. Verfahren nach einem der vorhergehenden Ansprüche,
dadurch gekennzeichnet, daß zur Anregung der Kernmagnetisierung in den beiderseits der Schicht befindlichen Bereichen ein oder zwei 90° Impulse - (HF1, HF2) verwendet werden.

9. Verfahren nach einem der vorhergehenden Ansprüche,

dadurch gekennzeichnet, daß der weitere Hochfrequenzimpuls (HF3) ein 90° Impuls ist.

10. Kernspintomograph zum Durchführen des Verfahrens nach Anspruch 1 mit einem Magneten zur Erzeugung eines homogenen stationären Magnetfeldes, einer Hochfrequenz-Spulenanordnung zur Erzeugung eines hochfrequenten zum stationären Magnetfeld senkrechten Magnetfeldes, einer Gradienten-Spulenanordnung zur Erzeugung von in Richtung des stationären Magnetfeldes verlaufenden Magnetfeldern mit in verschiedenen Richtungen verlaufenden Gradienten, einem Hochfrequenzgenerator zur Speisung der Hochfrequenz-Spulenanordnung und mit Generatoren zur Speisung der Gradientenspulen sowie mit einer Steuereinheit zur Steuerung des Hochfrequenzgenerators und der Generatoren,

dadurch gekennzeichnet, daß die Steuerung so programmiert ist, daß zunächst wenigstens ein Hochfrequenzimpuls und ein magnetisches Gradientenfeld mit zur Schicht senkrechtem Gradienten erzeugt wird derart, daß in zwei beiderseits einer Schicht befindlichen Bereichen die Kernmagnetisierung angeregt wird und daß dann ein weiterer, - schmalbandiger Impuls erzeugt wird, der die Kernmagnetisierung in einem einen Teil der Bereiche und die Schicht enschliessenden Bereich anregt.

FIG.1

FIG.4a

FIG.4b

FIG.4c

FIG.4d

FIG.4e

FIG.2

FIG.3